# EUROPEAN PATENT APPLICATION

(11) **EP 3 460 596 A1**
(43) Date of publication of application: **27.03.2019**
(21) Application number: 18156398.2
(22) Date of filing: 13.02.2018
(51) Int. Cl.: G05B 19/04, G05B 19/05

(54) **SUPPORT DEVICE AND SUPPORT PROGRAM**

(30) Priority: 26.09.2017 JP 2017185147
(71) Applicant: OMRON CORPORATION, Kyoto-shi, Kyoto 600-8530 (JP)
(72) Inventor: NAKANO, Masahiko, Kyoto-shi, Kyoto 600-8530 (JP); YAMAMOTO, Eiji, Kyoto-shi, Kyoto 600-8530 (JP)
(74) Representative: Becker Kurig Straus

(57) **Abstract**

A support device (200) is provided for efficiently using a limited process resource that can be provided by a single control device (100) and a support program for realizing the support device. The support device (200) includes a load estimation means (52, 54) which calculates a degree of a load necessary for analyzing a syntax of a command included in an application program and a priority calculation means (62) which calculates a priority to be set for a second task (20) based on the calculated degree of the load.

## Description

### BACKGROUND

### Technical Field

The present invention relates to a support device which is connected to a control device for controlling a control target and a support program for realizing the support device.

### Description of Related Art

Various factory automation (FA) technologies have been widely distributed in production sites. An FA system includes not only a control device such as a programmable logic controller (PLC) but also various actuators capable of executing an advanced operation such as computer numerical control (CNC) and a robot. Such an FA system tends to increase in size.

For example, Japanese Laid-open No. 2001-027904 A (Patent Document 1) discloses a numerical control system capable of increasing the number of shafts to be controlled and synchronizing a plurality of CNC devices by connecting the plurality of CNC devices. In the numerical control system, a master unit and one or a plurality of slave units are connected to each other via a cable. Each of the master unit and the slave unit has a CNC processor and a PLC processor for executing a ladder program.

Further, Japanese Laid-open No. 2016-092544 A (Patent Document 2) discloses a control system which controls a first control object by a master control device and controls a second control object different from the first control object by a slave control device connected to the master control device via a network. The control system includes a master control device and a slave control device. Each of the master control device and the slave control device includes a robot controller having a different calculation processing unit in addition to a controller having a calculation processing unit.

In recent years, the processing capability of control devices has rapidly improved with advances in information and communication technology (ICT). FA systems have been realized using a plurality of dedicated devices in the related art, and there is a demand to realize one with a smaller number of control devices.

### SUMMARY

In the configurations disclosed in Patent Documents 1 and 2, since the plurality of processors or calculation processing units are distributed, the configuration may be redundant due to the synchronization process between the processors or calculation processing units.

The invention provides a control device capable of executing a plurality of tasks in parallel. Particularly, an object of the invention provides a support device for efficiently using limited process resources that can be provided by a single control device and a support program for realizing the support device.

According to an example of the disclosure, a support device connected to a control device including one or a plurality of processors is provided. The control device is configured to process a plurality of tasks based on priorities set for each of the tasks. The plurality of tasks includes a first task which includes a process of outputting a control command every first cycle according to an internal command, a second task which includes a process of sequentially generating the internal command by analyzing a syntax of at least a part of an application program described by an interpreter language every second cycle longer than the first cycle, and a third task which includes a different process from the first task and the second task. The support device includes a load estimation means which calculates a degree of a load necessary for analyzing a syntax of a command included in the application program and a priority calculation means which calculates a priority to be set for the second task based on the calculated degree of the load.

According to the above-described disclosure, it is possible to optimize the priority of the second task so that the internal command used in the first task is appropriately generated when the first to third tasks are executed by the control device. Accordingly, it is possible to execute a plurality of tasks cooperating with each other in a single control device while efficiently allocating process resources.

In the above-described disclosure, the support device may further include a suggestion means which suggests a priority to be set for the second task to a user.

According to the above-described disclosure, the user can determine the priority to be finally set while checking the calculated priority.

In the above-described disclosure, the support device may further include a setting means which reflects the setting of the priority for the second task in response to an input from the user.

According to the above-described disclosure, it is possible to set an arbitrary priority which is input by the user.

In the above-described disclosure, the application program includes one or a plurality of commands for defining a target trajectory. The second task may include a process of sequentially calculating passage points on the target trajectory and a process of generating the internal command based on a movement route including the plurality of calculated passage points. The load estimation means may calculate the degree of the load by reflecting at least one of a gap between the calculated passage points, the number of the passage points used to generate the internal command, and a length of the second cycle.

According to the above-described disclosure, it is possible to more accurately calculate the degree of the load by considering the parameter affecting the computation load in the second task.

In the above-described disclosure, the load estimation means may calculate the degree of the load by referring to computation load coefficient information specifying a computation load coefficient for each command.

According to the above-described disclosure, it is possible to calculate the degree of the load in consideration of a variation in different computation load for each command included in the application program.

In the above-described disclosure, the support device may further include a learning means which acquires an execution state of the second task in the control device and updates the computation load coefficient information based on the acquired execution state.

According to the above-described disclosure, since the value of the computation load coefficient information which is logically determined in advance can be determined by reflecting the state of the computation load generated by the actual control device, more accurate computation load coefficient information can be generated

In the above-described disclosure, the support device may further include an emulator which simulates the control device; and a second priority calculation means which calculates a priority to be set for the second task based on a degree of an actual computation load acquired by executing the tasks in the emulator.

According to the above-described disclosure, since the priority can be calculated in consideration of the computation load generated in a substantially real environment by the execution of the program in the control device, a more appropriate priority can be calculated.

In the above-described disclosure, the support device may further include a third priority calculation means which calculates a priority to be set for the second task based on the degree of the actual computation load acquired by executing the tasks in the control device.

According to the above-described disclosure, since the priority can be calculated in consideration of the computation load generated by the execution of the program in the actual control device, a more appropriate priority can be calculated.

According to another example of the disclosure, a support program for realizing a support device connected to a control device including one or a plurality of processors is provided. The control device is configured to process a plurality of tasks based on priorities set for each of the tasks. The plurality of tasks includes a first task which includes a process of outputting a control command every first cycle according to an internal command, a second task which includes a process of sequentially generating the internal command by analyzing a syntax of at least a part of an application program described by an interpreter language every second cycle longer than the first cycle, and a third task which includes a different process from the first task and the second task. The support program causes a computer to execute: calculating a degree of a load necessary for analyzing a syntax of a command included in the application program; and calculating a priority to be set for the second task based on the calculated degree of the load.

According to the above-described disclosure, it is possible to optimize the priority of the second task so that the internal command used in the first task is appropriately generated when the first to third tasks are executed in the control device. Accordingly, it is possible to execute a plurality of tasks cooperating with each other in a single control device while efficiently allocating process resources.

According to the invention, a plurality of tasks can be executed in parallel by efficiently using limited process resources that can be provided by a single control device.

### BRIEF DESCRIPTION OF THE DRAWINGS

FIG.1(A) and FIG.1(B) are time charts respectively showing a task execution example of a control device according to the embodiment.
FIG. 2 is a schematic diagram showing an application example of a priority calculation process according to the embodiment.
FIG. 3 is a schematic diagram showing an overall configuration example of a control system according to the embodiment.
FIG. 4 is a block diagram showing a hardware configuration example of the control device according to the embodiment.
FIG. 5 is a block diagram showing a function configuration example of the control device according to the embodiment.
FIG. 6(A) and FIG.6(B) are schematic diagrams respectively illustrating an example of an internal command generation process of the control device according to the embodiment.
FIG. 7 is a block diagram showing a hardware configuration example of a support device according to the embodiment.
FIG. 8 is a block diagram showing a function configuration example of the support device according to the embodiment.
FIG. 9 is a block diagram showing a function configuration example of a computation load calculation module of the support device according to the embodiment.
FIG. 10 is an example of a table for determining the priority to be referred to by a priority calculation module of the support device according to the embodiment.
FIG. 11 is a schematic diagram showing an example of a user interface screen to be provided by the support device according to the embodiment.
FIG. 12 is a schematic diagram showing another example of the user interface screen to be provided by the support device according to the embodiment.
FIG. 13 is a schematic diagram showing still another example of the user interface screen to be provided by the support device according to the embodiment.
FIG. 14 is a flowchart showing a process sequence of a priority calculation process according to the embodiment.
FIG. 15 is a schematic diagram illustrating a process of learning a computation load coefficient table in the priority calculation process according to the embodiment.
FIG. 16 is a schematic diagram illustrating the priority calculation process using an emulator according to the embodiment.
FIG. 17 is a schematic diagram illustrating the priority calculation process using an actual device according to the embodiment.

### DESCRIPTION OF THE EMBODIMENTS

An embodiment of the invention will be described in detail with reference to the drawings. Additionally, the same or corresponding parts in the drawings are denoted by the same reference numerals and the description thereof will not be repeated.

### <A. Application Example>

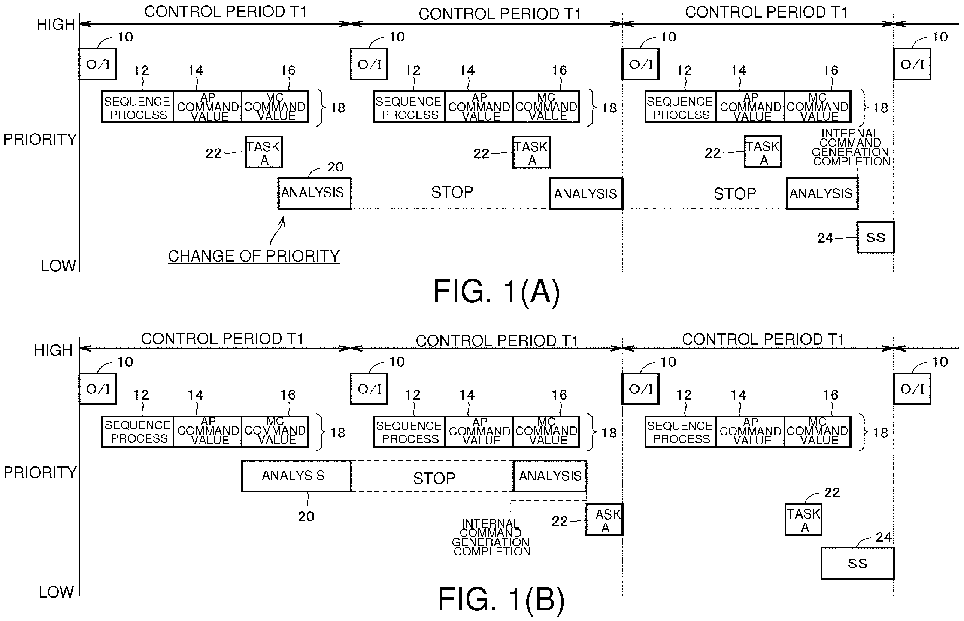

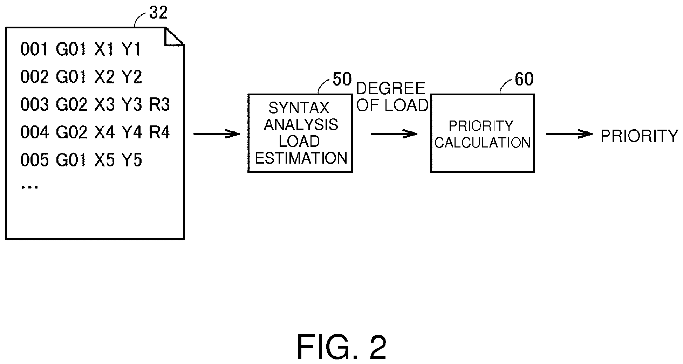

First, an example of an application case of the invention will be described with reference to FIG.1(A), FIG.1(B) and 2.

A control device 100 according to the embodiment is configured to execute a user program and an application program in parallel.

In the present specification, "user program" includes a program which can be entirely scanned every execution and can output a control command every execution. Basically, the user program is arbitrarily generated by a user in response to a control target or an application. Examples of the user program include a program having one or a plurality of commands described according to the international standard IEC 61131-3 specified by the International Electrotechnical Commission (IEC). The user program may include a sequence command and/or a motion command. In addition, the user program is not limited to the command described according to the international standard IEC 61131-3 but may include a command that is independently specified by a manufacturer or a vender of a programmable logic controller (PLC). In this way, the user program is suitable for control requiring timeliness and high speed.

In the present specification, "sequence command" is a term including one or a plurality of commands described by one or a plurality of logic circuits for computing an input value, an output value, an internal value, and the like. In one control cycle, the sequence command is executed from the beginning to the end, and in the next control cycle, the "sequence command" is executed again from the beginning to the end.

In the present specification, "motion command" is a term including one or a plurality of commands to calculate a numerical value such as a position, a speed, an acceleration, a jerk (the rate of change of acceleration), an angle, an angular velocity, an angular acceleration, and an angular jerk as a control command for an actuator such as a servo motor. The motion command is also executed from the beginning to the end of a program (motion program) of the motion command described by a function block, a numerical expression, or the like in one control cycle.

The control command output by executing the user program at each control cycle typically includes an on/off state of a digital output determined according to the sequence command and an analog output calculated according to the motion command.

In the present specification, "application program" includes an arbitrary program described by an interpreter language. The control device 100 executes a process while analyzing the syntax of the command described by the interpreter language in the application program. Examples of the application program include a program describing behaviors in computer numerical control (CNC) (hereinafter, also referred to as "NC program") and a program for controlling a robot. In general, the NC program is described using a "G language" and the program for controlling the robot is often described using a dedicated robot language (for example, an "M language"). The application program includes one or a plurality of commands for defining a target trajectory.

In the following description, there is a case where a "control application" includes, for example, a device or machine performing specific processing or operation using computer numerical control (CNC) and/or a robot and such control.

Originally, the application program described by the interpreter language is not suitable for a process for outputting the control command every predetermined cycle. For that reason, in the embodiment, an internal command suitable for the output of the control command for every control cycle is generated. Such an internal command may be in any code as long as the control command can be output every control cycle. Typically, the internal command may be one or a plurality of functions using time as an input variable or one or a plurality of commands using time as an argument.

FIG.1(A) and FIG.1(B) are time charts respectively showing a task execution example of the control device 100 according to the embodiments. Referring to FIG.1(A) and FIG.1(B), the control device 100 according to the embodiment processes a plurality of tasks based on the priority set for each task.

In the present specification, "task" means the unit of execution of a process including one or a plurality of processes. An execution cycle may be set for each task in addition to the priority. When the execution cycle is set, a scheduler triggers the execution of the task in accordance with the set execution cycle.

The execution of the plurality of tasks is managed by the function of the control device 100 called the scheduler. The scheduler allocates the process time (hereinafter, also referred to as "processor resources") of one or a plurality of processors of the control device 100 to a target task.

The plurality of tasks typically includes a task which is repeatedly executed every control cycle T1 and a task which is executed with a longer cycle than the control cycle T1. FIG.1(A) and FIG.1(B) show examples of five tasks (first to fifth tasks) set for each priority.

The first task 10 includes an input/output refresh process (described as "O/I" in FIG.1 (A) and FIG. 1(B)) for updating an input value and a control command with a field.

The second task 18 includes a sequence command execution process 12, an output process 14 of outputting a control command in accordance with an internal command generated from an application program, and an output process 16 of outputting a control command in accordance with a motion command included in a user program. That is, the second task 18 includes a process of outputting a control command every control cycle T1 (first cycle) in accordance with the internal command.

The first task 10 and the second task 18 are triggered every control cycle T1. For that reason, a relatively high priority is set for the first task 10 and the second task 18. In the description below, the first task 10 and the second task 18 will also be referred to as "high-priority tasks."

The third task 20 includes a process of sequentially generating an internal command by analyzing a syntax of an application program. An operation of analyzing the syntax of the application program is executed every application execution cycle (second cycle) longer than the control cycle T1 (the first cycle). That is, the third task 20 includes a process of sequentially generating an internal command by analyzing the syntax of at least a part of an application program described by an interpreter language every application execution cycle (second cycle) longer than the control cycle T1 (the first cycle).

The fourth task 22 includes an arbitrary process provided by the control device 100. The fifth task 24 includes a process (hereinafter, also referred to as "system service") such as data communication between the control device 100 and an external device. In this way, the fourth task 22 and the fifth task 24 include processes different from those of the second task 18 and the third task 20.

Different priorities are set for each of the first to fifth tasks and the processor resources are allocated in accordance with the set priorities. As a typical example of allocating the processor resources, the third task 20, the fourth task 22, and the fifth task 24 are executed during a period in which the high-priority tasks are not executed. In the description below, the third task 20, the fourth task 22, and the fifth task 24 will also be referred to as "low-priority tasks" in contrast with the first task 10 and the second task 18 (the high-priority tasks).

FIG. 1(A) shows an example in which a higher priority is set for the fourth task 22 than for the third task 20. FIG. 1(B) shows a process example when the priority of the third task 20 is set to be higher than the priority in the case of FIG. 1(A).

In the example shown in FIG. 1(A), the first task 10 and the second task 18 are repeatedly executed every control cycle T1. In each control cycle T1, the third to fifth tasks are executed in response to the priority during a period in which the first task 10 and the second task 18 are not executed.

The processor resources are allocated to the fourth task 22 every control cycle T1. Meanwhile, since the processor resources are allocated to the third task 20 only during a period in which none of the first task 10, the second task 18, and the fourth task 22 is executed, a time corresponding to three control cycles T1 is required for the completion of one process of the third task 20. That is, a time three times the control cycle T1 is required until a dedicated process is completed after the third task 20 is triggered.

In the example shown in FIG. 1(B), the processor resources are preferentially allocated to the third task 20 during a period in which neither of the first task 10 and the second task 18 is executed. As a result, since more processor resources are allocated to the third task 20 compared to the case of FIG. 1(A), it is possible to complete a dedicated process within a time two times the control cycle T1 after the third task 20 is triggered. That is, it is possible to generate the internal command within a shorter time from the code of the process target of the application program.

In FIG. 1(B), since more processor resources can be allocated compared to the case of FIG. 1(A), more internal commands can be generated in this case by executing one process.

In the control device 100 according to the embodiment, the third task 20 generates an internal command by analyzing the syntax of an application program and the second task 18 sequentially uses the internal command generated in the third task 20 for the calculation of the control command (that is, the internal command is "consumed" for each control cycle T1). In this way, competition arises between the generation of the internal command by the third task 20 and the use of the internal command by the second task 18.

As shown in FIG. 1(B), when the processor resources are sufficiently allocated to the third task 20, an internal command can be generated in advance to a certain degree prior to the use of the internal command by the second task 18. Meanwhile, as shown in FIG. 1(A), when the processor resources cannot be sufficiently allocated to the third task 20, the use of the internal command by the second task 18 may be superior and the generation of the internal command by the third task 20 may be awaited.

Here, in the embodiment, the degree of the load necessary for analyzing the syntax of the application program is calculated in advance and the priority to be set for the third task 20 is calculated based on the calculated degree of the load. More specifically, in FIG. 1, it is estimated whether to set the priority shown in FIG. 1(A) or the priority shown in FIG. 1(B) in advance.

FIG. 2 is a schematic diagram showing an application example of a priority calculation process according to the embodiment. Referring to FIG. 2, an application program 32 includes one or a plurality of commands. A load estimation process 50 is executed for estimating a degree of a load at the time of analyzing the syntax of the application program 32. Based on the degree of the load output by the load estimation process 50, a priority calculation process 60 is executed for calculating the priority. By such a process, it is possible to calculate the priority to be set for the task including a process of generating an internal command by analyzing the syntax of the application program 32 when the target application program 32 is executed by the control device 100.

In this way, in the load estimation process 50, the degree of the load necessary for analyzing the syntax of the command included in the application program 32 is calculated. Then, in the priority calculation process 60, the priority to be set for the third task 20 (the second task) shown in FIG. 1 is calculated based on the calculated degree of the load. The calculated priority may be suggested to a user or may be automatically set as the priority of the target task.

The functions of the load estimation process 50 and the priority calculation process 60 may be provided in the control device 100 itself, or may be provided in the support device connected to the control device 100. Alternatively, the functions may be provided in an information processing device completely independent from the control device 100.

In the embodiment, the degree of the load necessary for analyzing the syntax of the command included in the application program 32 can be estimated and the appropriate priority set for the task for analyzing the syntax of the application program 32 can be determined in advance in response to the degree of the estimated load.

Since the appropriate priority can be determined in advance, it is possible to prevent a problem in which the process of generating the internal command by analyzing the syntax of the application program 32 is late due to the low priority and to prevent a problem in which sufficient processor resources are not allocated to other tasks and a required process speed cannot be obtained due to the high priority.

Further, since the appropriate priority can be determined in advance, it is not necessary to set the priority of each task by trial and error in order to efficiently perform the adjustment operation of the control device 100 executing a plurality of kinds of program. That is, it is possible to reduce the number of steps for adjusting the priority of each task executed by the control device 100.

Hereinafter, more detailed configurations and processes of the control device 100 and the support device according to the embodiment of the disclosure will be described as the detailed application examples.

### <B. Overall Configuration Example Of A Control System>

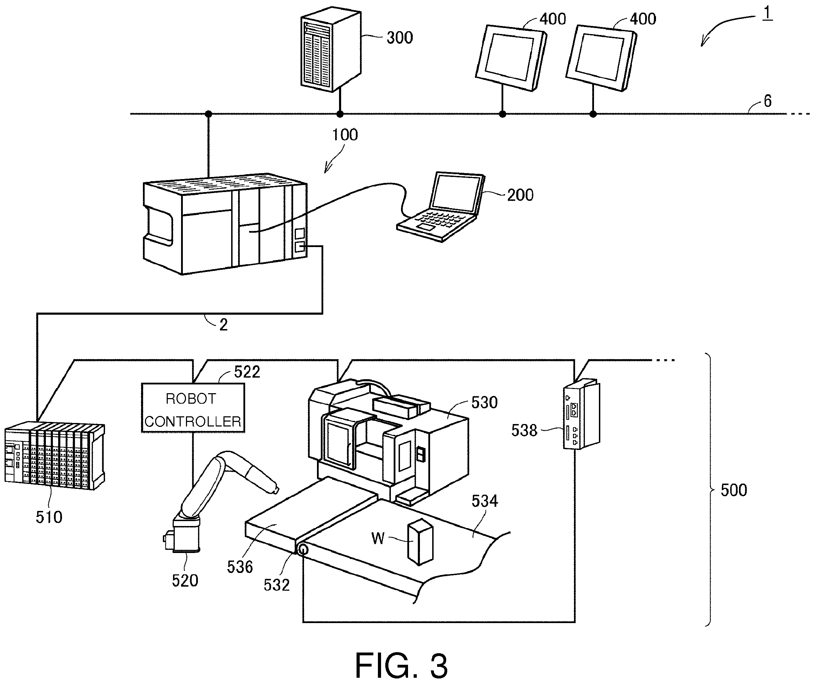

First, an overall configuration example of the control system 1 including the control device 100 according to the embodiment will be described. FIG. 3 is a schematic diagram showing an overall configuration example of the control system 1 according to the embodiment. FIG. 3 shows the control system 1 based on the control device 100 according to the embodiment.

Referring to FIG. 3, the control device 100 corresponds to an industrial controller which controls targets such as various facilities or devices. The control device 100 is a kind of computer that executes a control computation to be described below and may be typically implemented as a programmable logic controller (PLC). The control device 100 may be connected to many kinds of field devices 500 via a field network 2. The control device 100 exchanges data with one or a plurality of field devices 500 via the field network 2. In general, a "field network" is referred to as a "field bus," but will only be referred to as a "field network" in the description below for convenience of description. That is, "field network" in the present specification is a concept that may include "field bus" in addition to the "field network" in a narrow sense.

It is desirable that a bus or a network that performs periodic communication in which the arrival time of data is guaranteed be adopted as the field network 2. EtherCAT (registered trademark), EtherNet/IP (registered trademark), DeviceNet (registered trademark), CompoNet (registered trademark), and the like are known as a bus or a network for performing such periodic communication.

An arbitrary field device 500 can be connected to the field network 2. The field device 500 includes an actuator for giving some physical action to a manufacturing apparatus or a production line (hereinafter, also referred to as "field") and an input/output device for exchanging information with the field.

Data is exchanged between the control device 100 and the field device 500 via the field network 2, but the exchanged data is updated in a very short cycle on the order of several 100 µsec (microseconds) to several tens of msec (milli seconds). Such exchanging of data includes a process of transmitting data collected or generated in the field device 500 (hereinafter, also referred to as "input data") to the control device 100 and a process of transmitting data such as a control command to the field device 500 from the control device 100 (hereinafter, also referred to as "output data"). The process of updating such exchanged data corresponds to the above-described "input/output refresh process."

In the configuration example shown in FIG. 3, the field device 500 includes a remote input/output (I/O) device 510, a robot 520, a robot controller 522, a CNC machine tool 530, a servo driver 538, and a servomotor 532.

The servomotor 532 conveys a workpiece W to a work table 536 disposed in front of the CNC machine tool 530 by driving a conveyor 534. The robot 520 places the unprocessed workpiece W on the work table 536 in the CNC machine tool 530, takes the processed workpiece W out of the CNC machine tool 530, and places it on the work table 536.

The field device 500 is not limited to these examples, but may be any device that collects input data (for example, a visual sensor or the like) and an arbitrary device that gives some action according to output data (for example, an inverter device or the like).

The remote I/O device 510 typically includes a communication coupler for communicating via the field network 2 and an input/output unit (hereinafter, also referred to as an "I/O unit") for acquiring input data and outputting output data.

The remote I/O device 510 is connected with devices for collecting input data of input relays and various sensors (for example, analog sensors, temperature sensors, vibration sensors, etc.) and devices for giving some action to a field such as output relays, contactors, servo drivers, and other arbitrary actuators.

The robot controller 522 calculates a trajectory and an angle of each axis according to a control command (a position command or a speed command, etc.) from the control device 100 and drives a servomotor or the like constituting the robot 520 according to the calculation result.

The CNC machine tool 530 processes an arbitrary object by controlling a machining center or the like according to a program specifying a position, a speed, and the like. The CNC machine tool 530 typically includes machining devices for lathe machining, milling machining, electric discharge machining, and the like.

The servo driver 538 drives the servomotor 532 in accordance with a control command (for example, a position command or a speed command) from the control device 100.

The control device 100 may be connected to other devices via the high-order network 6. A general network protocol such as Ethernet (registered trademark) or EtherNet/IP (registered trademark) may be adopted for the high-order network 6. More specifically, one or a plurality of server devices 300 and one or a plurality of display devices 400 may be connected to the high-order network 6.

As the server device 300, a database system, a manufacturing execution system (MES), and the like are assumed. The manufacturing execution system is used to monitor and manage the entire production by acquiring information from manufacturing apparatuses and facilities to be controlled and can also handle order information, quality information, shipping information, etc. The present invention is not limited to this, and a device providing the information service may be connected to the high-order network 6. For the information system service, a process of acquiring information from a manufacturing apparatus or facility to be controlled and performing macroscopic or microscopic analysis is assumed. For example, data mining for extracting some characteristic tendency included in information from a manufacturing apparatus or facility to be controlled or a machine learning tool for machine learning based on information from facilities and machines to be controlled are assumed.

The display device 400 receives an operation from the user to output a command in response to the operation of the user to the control device 100 and to graphically display a calculation result or the like in the control device 100.

A support device 200 is connectable to the control device 100. The support device 200 is a device which supports preparations necessary for the control device 100 to control the target. Specifically, the support device 200 provides a development environment (a program creation editing tool, a parser, a compiler, etc.) of a program executed by the control device 100, a setting environment for setting (allocating) parameters of the control device 100 and various devices connected to the control device 100, a function of outputting a generated user program to the control device 100, and a function of correcting and modifying the on-line user program executed on the control device 100. The support device 200 according to the embodiment can provide a function of the priority calculation process shown in FIG. 2 described above. The priority calculation process will be described later.

### <C. Hardware Configuration Example Of Control Device>

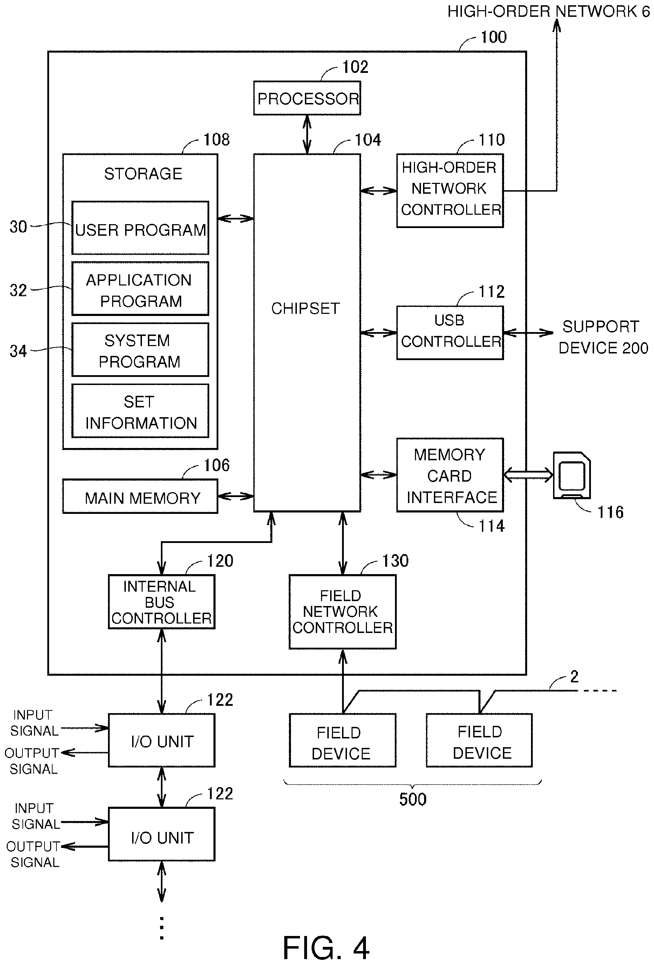

Next, a hardware configuration example of the control device 100 according to the embodiment will be described. FIG. 4 is a block diagram showing the hardware configuration example of the control device 100 according to the embodiment.

Referring to FIG. 4, the control device 100 is a calculation processing unit called a CPU unit and includes a processor 102, a chipset 104, a main memory 106, a storage 108, a high-order network controller 110, a USB (Universal Serial Bus) controller 112, a memory card interface 114, an internal bus controller 120, and a field network controller 130.

The processor 102 includes a CPU (Central Processing Unit), a MPU (Micro Processing Unit), a GPU (Graphics Processing Unit), and the like. The processor 102 may include a plurality of cores and a plurality of the processors 102 may be arranged. That is, the control device 100 includes one or a plurality of processors 102 and/or the processor 102 including one or a plurality of cores. The chipset 104 realizes the entire process of the control device 100 by controlling the processor 102 and the peripheral element. The main memory 106 is configured as a volatile storage device such as DRAM (Dynamic Random Access Memory) or SRAM (Static Random Access Memory). The storage 108 is configured as, for example, a nonvolatile storage device such as HDD (Hard Disk Drive) or SSD (Solid State Drive).

The processor 102 realizes a control and various processes to be described later corresponding to the control target by reading various programs stored in the storage 108 and developing and executing the program in the main memory 106. The storage 108 stores the user program 30 and the application program 32 created in response to the manufacturing apparatus or facility to be controlled in addition to the system program 34 for realizing a basic function.

The high-order network controller 110 controls exchanging of data with the server device 300 or the display device 400 (see FIG. 4) via the high-order network 6. The USB controller 112 controls exchanging of data with the support device 200 via a USB connection.

The memory card interface 114 has a configuration in which a memory card 116 is attachable thereto and detachable therefrom and is able to record data in the memory card 116 and read various data (user program, trace data, etc.) from the memory card 116.

The internal bus controller 120 controls exchanging of data with an I/O unit 122 attached to the control device 100. The field network controller 130 controls exchanging of data with a field device via the field network 2.

FIG. 4 shows a configuration example in which a necessary function is provided by the execution of the program in the processor 102, but a part or the entirety of the provided function may be provided in a dedicated hardware circuit (for example, ASIC or FPGA). Alternatively, a main part of the control device 100 may be realized by using hardware (for example, an industrial personal computer based on a general-purpose personal computer) complying with a general-purpose architecture. In this case, a plurality of OSs (Operating Systems) having different uses may be executed in parallel using a virtualization technique and required applications may be executed on each OS.

In the control system 1 shown in FIG. 4, the control device 100, the support device 200, and the display device 400 are separated from one another, but a configuration of integrating a part or the entirety of these functions in a part of a single device may be adopted.

### <D. Function Configuration Example of Control Device>

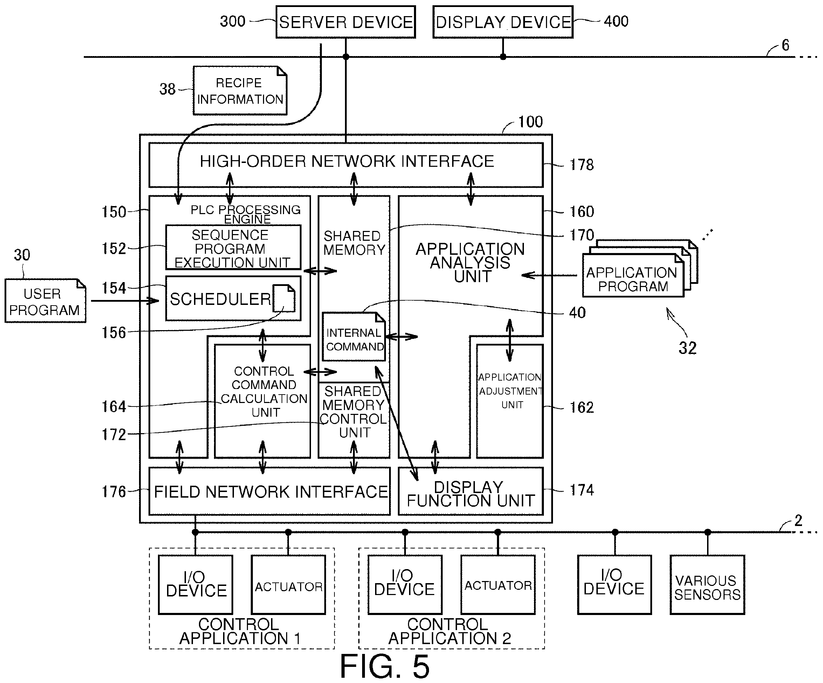

Next, a function configuration example of the control device 100 according to the embodiment will be described. FIG. 5 is a block diagram showing the function configuration example of the control device 100 according to the embodiment.

FIG. 5 shows a configuration example in which the control device 100 controls the control application 1 and the control application 2. Each of the control application 1 and the control application 2 typically includes I/O devices such as a relay or a contactor and various actuators such as a servomotor. The control device 100 is also connected to other I/O devices and various sensors via the field network 2 in addition to the control application 1 and the control application 2.

The control device 100 receives a command of starting/ending the production from the server device 300 or the like connected thereto via the high-order network 6. The server device 300 may transmit recipe information 38 (information such as a production type or a parameter suitable for a production) to the control device 100. The control device 100 may be connected to other control devices 100 (not shown) via the network.

Referring to FIG. 5, the control device 100 includes a PLC processing engine 150, an application analysis unit 160, an application adjustment unit 162, a control command calculation unit 164, a shared memory 170, a shared memory control unit 172, a display function unit 174, a field network interface 176, and a high-order network interface 178.

The PLC processing engine 150 manages the execution of the user program 30 and the entire process of the control device 100. More specifically, the PLC processing engine 150 includes a sequence program execution unit 152 and a scheduler 154.

The sequence program execution unit 152 executes (scans) the user program 30 every control cycle T1 and outputs a control command.

The scheduler 154 is used to adjust a procedure of a process executed by the control device 100 and specifically allocates the processor resources to one or a plurality of tasks based on a predetermined priority. The scheduler 154 includes a task setting information 156 including information such as the priority set to each task and the process included in each task. Typically, the task setting information 156 is set or updated via the support device 200.

The application analysis unit 160 generates an internal command 40 by analyzing the syntax of at least a part of the application program 32. Different kinds of application program 32 may be provided for the application analysis unit 160. The application analysis unit 160 may execute the application program 32 stored in advance or may execute the application program 32 appropriately transmitted from the server device 300.

The control command calculation unit 164 calculates the control command in accordance with the motion command included in the user program 30 every control cycle T1. Further, the control command calculation unit 164 calculates the control command every control cycle T1 in accordance with the internal command 40 sequentially generated by the application analysis unit 160.

The sequence program execution unit 152 and the control command calculation unit 164 execute processes every control cycle T1 (the high-priority task). Meanwhile, a process on the application program 32 by the application analysis unit 160 is executed every application execution cycle (second cycle) integer times the control cycle T1 (the low-priority task).

The application adjustment unit 162 adjusts a process sequence or the like when a plurality of application programs 32 are processed by the application analysis unit 160.

The shared memory 170 stores data shared among the PLC processing engine 150, the application analysis unit 160, and the control command calculation unit 164. The shared data may be stored as a structure variable. For example, the internal command 40 which is sequentially generated by the application analysis unit 160 is sequentially written to the structure variable of the shared memory 170.

The shared memory control unit 172 performs exclusive control of reading and writing data for the shared memory 170 and an access or the like to the shared memory 170 in response to external requests. For example, the shared memory control unit 172 gives data on the shared memory 170 to the field network interface 176 so that the data is transmitted to the arbitrary field device 500 connected via the field network 2.

The display function unit 174 outputs data stored in the shared memory 170 and a process result or the like obtained by the application analysis unit 160 to the user or the like.

The field network interface 176 relays exchanging of data with the field device 500 connected via the field network 2.

The high-order network interface 178 relays exchanging of data with a device connected via the high-order network 6.

### <E. Internal Command Generation Process Example>

Next, a process example in which the application analysis unit 160 of the control device 100 generates the internal command 40 by analyzing the syntax of the application program 32 will be described.

In the control device 100 according to the embodiment, the application analysis unit 160 parses one or a plurality of commands specified in the application program 32 and generates the internal command 40 for calculating a command value for each control cycle based on the parsed contents. The generated internal command 40 is sequentially queued in the shared memory 170.

The internal command 40 may be a function capable of calculating a command value by using a variable in time as an input. That is, the internal command 40 may be a function in which the control command calculation unit 164 outputs a command value every control cycle. More specifically, the internal command 40 may be a function for specifying a relation between the time and the command value. As a variable involving with the time for specifying the internal command 40, a time, an elapsed time from a certain reference timing, an accumulative number of control cycles, and the like can be used.

By using such a function, the control command calculation unit 164 can output a command value during each control cycle by sequentially referring to the generated internal command 40.

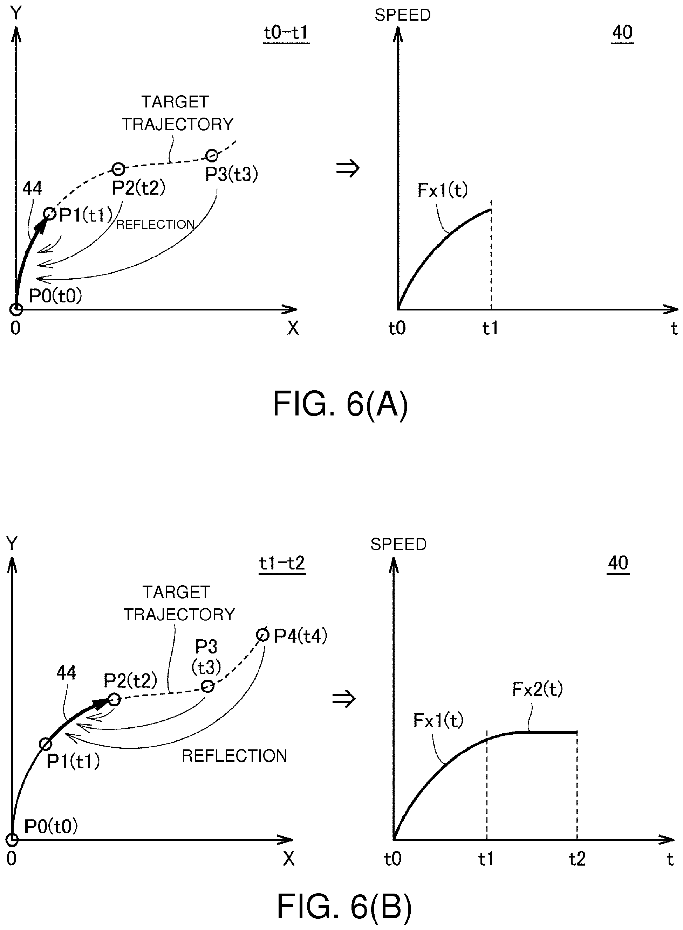

FIG. 6(A) and FIG.6(B) are schematic diagrams respectively illustrating an example of a process of generating the internal command 40 in the control device 100 according to the embodiment. FIG. 6(A) shows a procedure of a process of generating the internal command 40 during a period from the time t0 to the time t1 and FIG. 6(B) shows a procedure of a process of generating the internal command 40 during a period from the time t1 to the time t2.

Referring to FIG. 6(A), the application analysis unit 160 sequentially determines the target trajectory by sequentially analyzing the application program 32. The application analysis unit 160 sequentially calculates a passage point for each of predetermined cycles in the sequentially determined target trajectory. Each of the passage points is calculated based on the movement distance on the target trajectory and the movement speed on the target trajectory.

In the example shown in FIG. 6(A), the passage point P1 (t1) at the time t1, the passage point P2 (t2) at the time t2, and the passage point P3 (t3) at the time t3 are calculated in addition to the passage point P0 (t0) which is the initial position at the time t0.

The application analysis unit 160 calculates a movement route 44 from the passage point P0 (t0) to the passage point P1 (t1) based on the information of the passage points P0 (t0), P1 (t1), P2 (t2), and P3 (t3). The application analysis unit 160 generates a function Fx1(t) from the calculated movement route 44. Additionally, FIG. 6(A) only shows the function Fx1(t), but in fact, the internal command 40 is generated by the number of motors to be controlled at the same time.

Only the information of the passage point P0 (t0) and the passage point P1 (t1) may be used for the calculation of the movement route 44. However, the information of one or a plurality of passage points continuous to the passage point P1 (t1) may be reflected to more smoothly and accurately calculate the movement route 44. That is, it is possible to improve the control accuracy by generating the internal command 40 using the "estimating" operation.

Referring to FIG. 6(B), the application analysis unit 160 further analyzes the application program 32 to further determine the previous target trajectory during a period from the time t1 to the time t2. The application analysis unit 160 calculates a new passage point for the determined previous target trajectory. That is, the application analysis unit 160 newly calculates the passage point P4 (t4).

The application analysis unit 160 calculates the movement route 44 from the passage point P1 (t1) to the passage point P2 (t2) based on the information of the passage points P1 (t1), P2 (t2), P3 (t3), and P4 (t4). The application analysis unit 160 generates a function Fx2(t) from the calculated movement route 44. In addition, FIG. 6(B) only shows the function Fx2(t), but in fact, the internal command 40 is generated by the number of motors to be controlled at the same time.

As shown in FIG. 6(A) and FIG.6(B), in the "estimating" operation, the application analysis unit 160 generates the internal command 40 corresponding to the adjacent passage points 42 on the target trajectory based on the information of the passage points 42 continuous to the adjacent passage points 42 on the target trajectory.

By repeating the above-described process procedure, the internal commands for realizing the target trajectory are sequentially generated. In this way, the task of analyzing the syntax of the application program 32 includes a process of sequentially calculating the passage points on the target trajectory and a process of generating the internal command based on the movement route including the calculated passage points.

### <F. Hardware Configuration Example of Support Device>

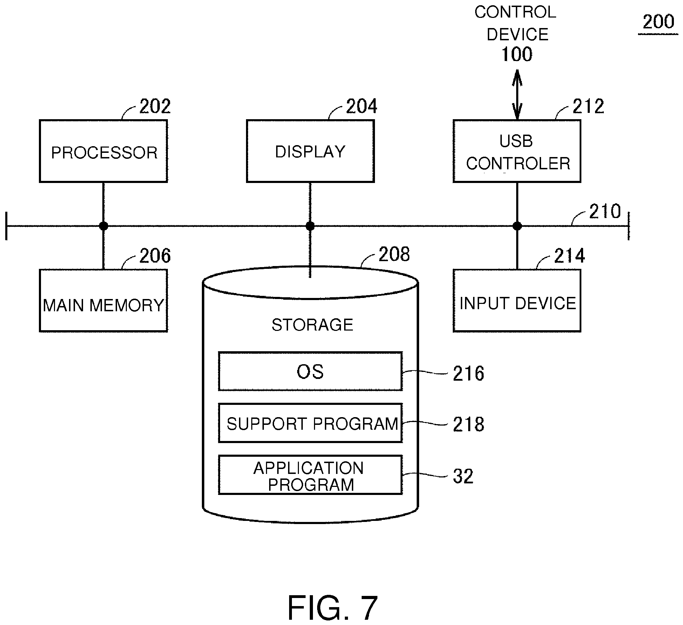

Next, a hardware configuration example of the support device 200 according to the embodiment will be described. FIG. 7 is a block diagram showing the hardware configuration example of the support device 200 according to the embodiment.

Referring to FIG. 7, the support device 200 is typically realized by the execution of a support program 218 on a personal computer having a generic architecture. More specifically, referring to FIG. 7, the support device 200 includes a processor 202, a display 204, a main memory 206, a storage 208, a USB controller 212, and an input device 214. These components are connected to one another via an internal bus 210.

The processor 202 includes a CPU, an MPU, a GPU, and the like and realizes various functions to be described below by reading various programs including the support program 218 and an OS 216 stored in the storage 208 and developing and executing them on the main memory 206. The main memory 206 is configured as a volatile storage device such as DRAM or SRAM. The storage 208 is configured as, for example, a nonvolatile storage device such as HDD or SSD.

The display 204 is a device which displays a computation result obtained by the processor 202 or the like and is configured as, for example, an LCD (Liquid Crystal Display) or the like.

The USB controller 212 exchanges data with the control device 100 via a USB connection.

The input device 214 is a device which receives an operation of the user and is configured as, for example, a keyboard or a memory.

As will be described below, the support device 200 according to the embodiment calculates the degree of the load necessary for analyzing the syntax of the application program 32 and calculates the priority to be set to the third task 20 based on the calculated degree of the load.

### <G. Function Configuration Example of Support Device>

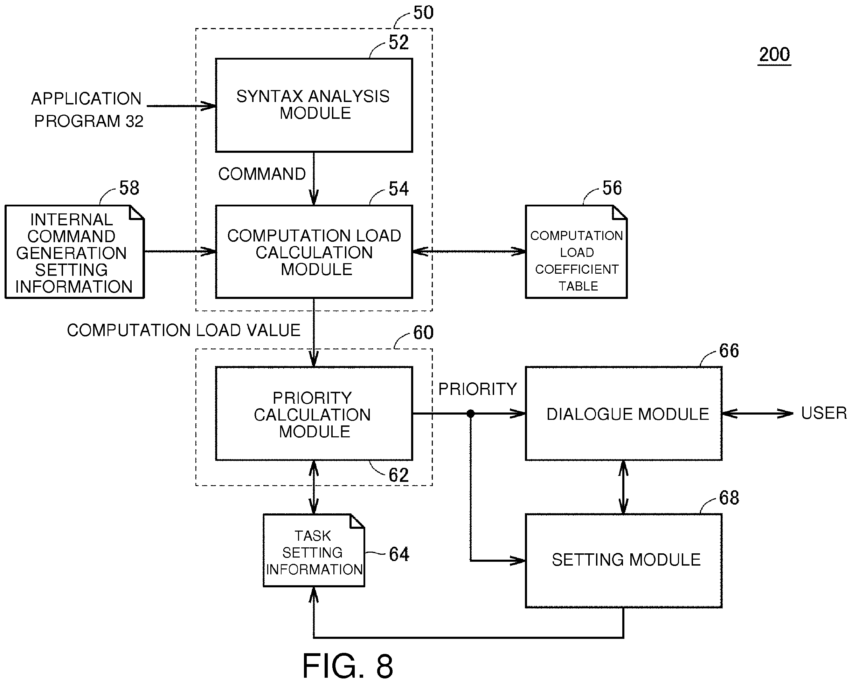

Next, a function configuration example of the support device 200 according to the embodiment will be described. FIG. 8 is a block diagram showing the function configuration example of the support device 200 according to the embodiment. Typically, the modules shown in FIG. 8 are executed when the processor 202 of the support device 200 executes the support program 218.

Referring to FIG. 8, the support device 200 includes a syntax analysis module 52 and a computation load calculation module 54 as a module for the load estimation process 50. The support device 200 further includes a priority calculation module 62 as a module for the priority calculation process 60. The support device 200 further includes a dialogue module 66 and a setting module 68.

The syntax analysis module 52 outputs one or a plurality of commands included in the application program 32 by analyzing the syntax of the application program 32. The computation load calculation module 54 acquires the computation load coefficient for each command output from the syntax analysis module 52 by referring to the computation load coefficient table 56. The computation load coefficient table 56 corresponds to the computation load coefficient information specifying the computation load coefficient for each command. The computation load calculation module 54 calculates a computation load value which is the degree of the load by referring to the computation load coefficient table 56. An example of the data structure of the computation load coefficient table 56 will be described below.

The syntax analysis module 52 refers to the internal command generation setting information 58 at the time of calculating the computation load value. The internal command generation setting information 58 includes a parameter at the time of generating the internal command 40 in accordance with the application program 32.

As an example of the parameter at the time of generating the internal command 40, (1) a length of the application execution cycle which is the execution cycle of the third task 20 for analyzing the syntax of the application program (see FIG. 1), (2) the number of the passage points used to generate the internal command 40 (see FIG. 6(A) and FIG.6(B)), and (3) a gap between the calculated passage points (a length of the cycle from the time t0 to the time t1 shown in FIG. 6(A) and FIG.6(B)) can be exemplified.

The computation load increases as the execution cycle shown in (1) becomes shorter, the computation load increases as the number of the passage points shown in (2) becomes larger, and the computation load increases as the gap between the passage points shown in (3) becomes shorter. Thus, the computation load calculation module 54 calculates the computation load value by multiplying the weight depending on the parameters shown in the above (1) to (3) by the computation load coefficient table 56. A part or the entirety of the parameters may be dynamically change during the execution of the application program 32. For that reason, the parameter applied to a certain part of the command group included in the application program 32 may be different from the parameter applied to the other part in some cases.

Meanwhile, it is not necessary to reflect all the parameters shown in the above (1) to (3), and only some of the parameters may be reflected. In this way, the computation load calculation module 54 calculates the computation load value (the degree of the load) by reflecting at least one of the parameters shown in the above (1) to (3).

The computation load calculation module 54 outputs the calculated computation load value. The computation load value may be statistical data such as an average value, a maximum value, a minimum value, and an intermediate value of values successively calculated when analyzing the syntax of the entire application program 32 or may be an accumulative value for the entirety or a part of a section. Alternatively, since there is a possibility that the time necessary for the process may be different for each command, a value obtained by standardizing the computation load value calculated for each command with the time required for analyzing the syntax of each command may be used.

The computation load value may be a dimensionless value, which may occupy the time of the processor, or may not occupy the time of the processor.

The priority calculation module 62 calculates the priority of the task involving with the analysis of the syntax of the corresponding application program 32 based on the computation load value calculated by the computation load calculation module 54. More specifically, the priority calculation module 62 calculates the priority for securing the processor resources necessary for satisfying the calculated computation load value by referring to the task setting information 64.

The task setting information 64 includes a process registered in each task which is currently set and the priority set for each task. The task setting information 64 may include statistical information on how much each task requires computation time in the control device 100.

The priority which is calculated by the priority calculation module 62 indicates the relative rank of the current set tasks. The priority calculation module 62 may calculate an appropriate priority in consideration of the processor resources and the like used by other tasks in the processor resources used in the control device 100.

The priority which is calculated by the priority calculation module 62 is output to the dialogue module 66 and the setting module 68. The dialogue module 66 suggests the priority calculated by the priority calculation module 62 to the user and receives a command from the user.

That is, the dialogue module 66 suggests the priority to be set in the task of analyzing the syntax of the application program 32 to the user. More specifically, the dialogue module 66 displays the priority calculated by the display 204 of the support device 200. In addition to the calculated priority, information used for calculating the priority and arbitrary load information may be displayed together.

The user operates the input device 214 or the like of the support device 200 to input an acceptance to the presented priority or a command for changing the presented priority. The dialogue module 66 outputs a command from the user to the setting module 68.

The setting module 68 reflects the setting of the priority for the task of analyzing the syntax of the application program 32 in response to the input of the user. More specifically, the setting module 68 sets the priority of the target task for the task setting information 64 based on the command of the user from the dialogue module 66 and the priority from the priority calculation module 62.

By the above-described process, the setting of the priority of the tasks for analyzing the syntax of the target application program 32 is completed. The updated task setting information 64 is given to the control device 100 in accordance with an arbitrary method.

### <H. Computation Load Calculation Module and Priority Calculation Module>

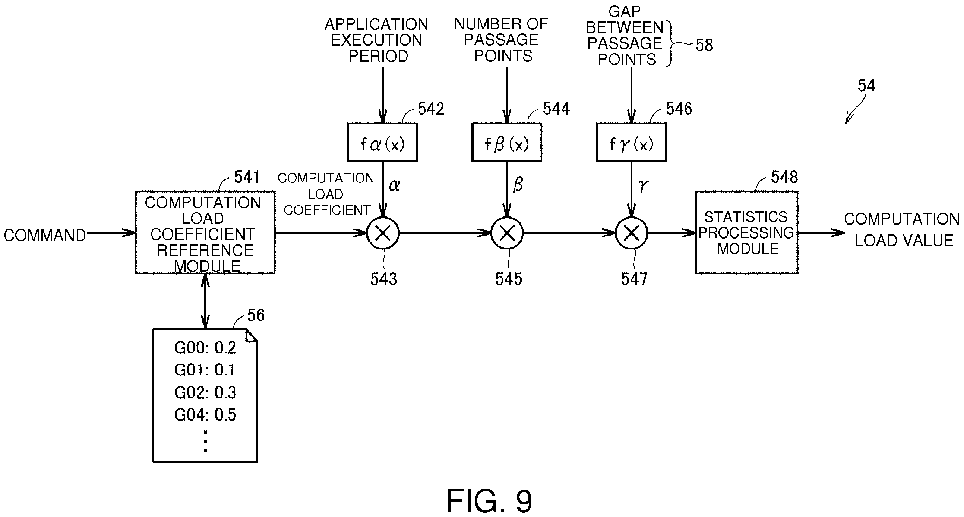

Next, more detailed process contents of the computation load calculation module 54 and the priority calculation module 62 shown in FIG. 8 will be described. FIG. 9 is a block diagram showing a function configuration example of the computation load calculation module 54 of the support device 200 according to the embodiment.

Referring to FIG. 9, the computation load calculation module 54 includes a computation load coefficient reference module 541, coefficient calculation modules 542, 544, and 546, coefficient multiplication modules 543, 545, and 547, and a statistics processing module 548.

The computation load coefficient reference module 541 acquires the computation load coefficient corresponding to the type of the input command by referring to the computation load coefficient table 56. A computation load coefficient for each command is specified in the computation load coefficient table 56.

The computation load coefficient specified in the computation load coefficient table 56 may be specified for each command (for example, described by a G language or an M language) or may be specified for an arithmetic operator and a logical operator. Furthermore, the computation load coefficient may be specified for a combination of a plurality of commands. Units for specifying computation load coefficients can be arbitrarily set according to the language.

Further, the computation load coefficient table 56 may be shared in a program group (also referred to as a "project") which is executed by the control device 100 and or may be generated individually in response to the performance or the like of the control device 100 executing the program group.

The coefficient calculation module 542 outputs a correction coefficient α corresponding to the input of the application execution cycle (included in the internal command generation setting information 58). The coefficient multiplication module 543 multiplies the correction coefficient α by the computation load coefficient from the computation load coefficient reference module 541 and outputs the result.

The coefficient calculation module 544 outputs a correction coefficient β corresponding to the input of the number (included in the internal command generation setting information 58) of the passage points used to generate the internal command 40. The coefficient multiplication module 545 multiplies the correction coefficient β by the result output from the coefficient multiplication module 543 and outputs the result.

The coefficient calculation module 546 outputs a correction coefficient γ corresponding to the input of the gap (included in the internal command generation setting information 58) of the passage points calculated at the time of generating the internal command 40. The coefficient multiplication module 547 multiplies the correction coefficient γ by the result output from the coefficient multiplication module 545 and outputs the result.

The statistics processing module 548 outputs a computation load value by statistically processing the corrected computation load coefficient calculated for each command included in the application program 32. More specifically, the statistics processing module 548 calculates an average value, a maximum value, a minimum value, an intermediate value, and the like for the corrected computation load coefficient for each command.

With the above-described function configuration, the computation load value is output.

Next, the priority calculation module 62 calculates an appropriate priority in consideration of the processor resources and the like used by other tasks among the processor resources which can be used in the control device 100. More specifically, the priority calculation module 62 estimates the size of the processor resources necessary for executing other tasks and calculates the priority based on the estimated processor resources.

Alternatively, the priority calculation module 62 may calculate the priority in accordance with a predetermined rule based on the magnitude of the calculated computation load value.

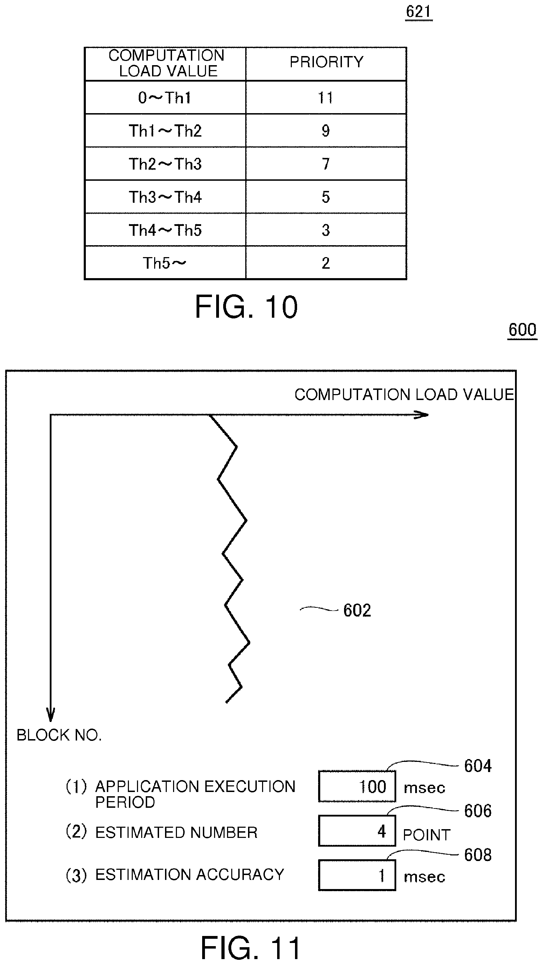

FIG. 10 shows an example of a table for determining the priority which is referred by the priority calculation module 62 of the support device 200 according to the embodiment. Referring to FIG. 10, a priority corresponding to the range of the computation load value is specified in advance in the priority table 621 and the priority calculation module 62 can uniquely determine the priority corresponding to the computation load value calculated by the computation load calculation module 54.

Additionally, the priority calculation method is not limited to the above-described method and an arbitrary method can be adopted.

### <I. User Interface Screen Example>

Next, an example of the user interface screen which is provided by the priority calculation module 62 and the dialogue module 66 will be described.

FIG. 11 is a schematic diagram showing an example of the user interface screen which is provided by the support device 200 according to the embodiment. Referring to FIG. 11, the user interface screen 600 shows a change in computation load value calculated by each command included in the application program 32. A trend graph 602 indicates a computation load value for each block number describing the command. The user can recognize a block having a relatively high computation load of the application program 32 by referring to the trend graph 602.

The user interface screen 600 includes a display window 604 which shows the length of the application execution cycle, a display window 606 which shows the number of the passage points used to generate the internal command 40, and a display window 608 which shows a gap between the passage points calculated when generating the internal command 40.

The user can freely change the set values of the display windows 604, 606, and 608. In accordance with a change of any set value, the computation load value may be calculated again.

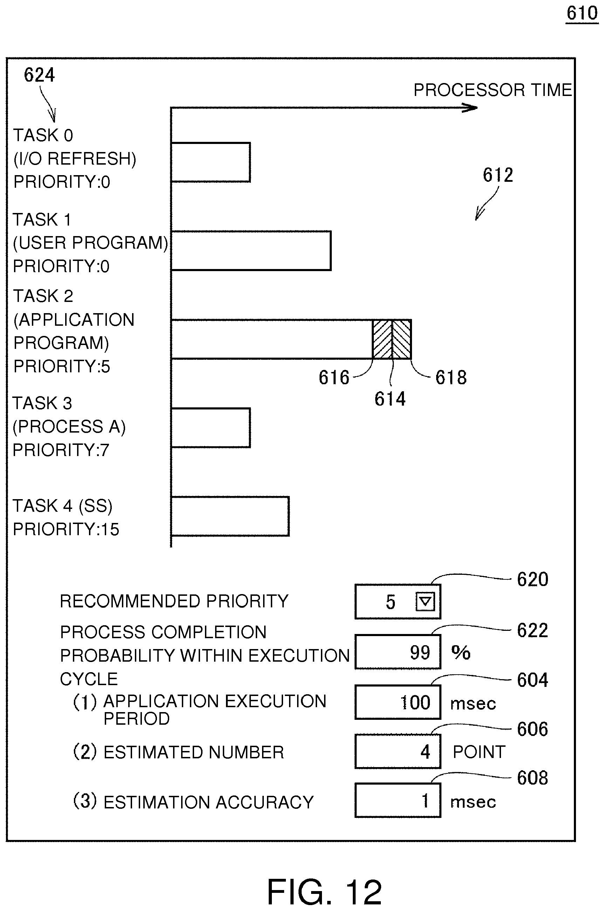

FIG. 12 is a schematic diagram showing another example of the user interface screen which is provided by the support device 200 according to the embodiment. Referring to FIG. 12, a user interface screen 610 indicates the size of the processor resource which is used in each task executed by the control device 100. A bar graph 612 indicates the length of the processor time for each task. Each task displays task attribute information 624 showing the number of the task and the set priority.

For the task to be evaluated in the bar graph 612, a minimum value 616 and a maximum value 618 are shown based on a change in the calculated computation load value in addition to an average value 614 of the processor time.

The user can recognize a task having a relatively high computation load among the plurality of tasks executed in the control device 100 by referring to the bar graph 612.

The user interface screen 610 includes a display window 620 which shows a recommended priority calculated by the priority calculation module 62 and a display window 622 which shows the probability that the syntax analysis of the target application program 32 can be completed within a predetermined application execution cycle (hereinafter also referred to as a "process completion probability within an execution cycle").

The process completion probability within the execution cycle indicates the possibility that the syntax analysis process for the application program 32 started at each start timing can be completed within a predetermined application execution cycle and is calculated based on the magnitude and the variation of the computation load value calculated for the target application program 32. The process completion probability within the execution cycle may be statistically calculated. The user may recognize the certainty of the priority set for the analysis process of the application program 32 by referring to the value of the process completion probability within the execution cycle.

The user can freely change the priority displayed in the display window 620. In response to the change of the priority, the process completion probability within the execution cycle may be calculated again.

The user interface screen 610 may also include the display window 604 which shows the length of the application execution cycle, the display window 606 which shows the number of the passage points used to generate the internal command 40, and the display window 608 which shows the gap between the passage points used to calculate the internal command 40.

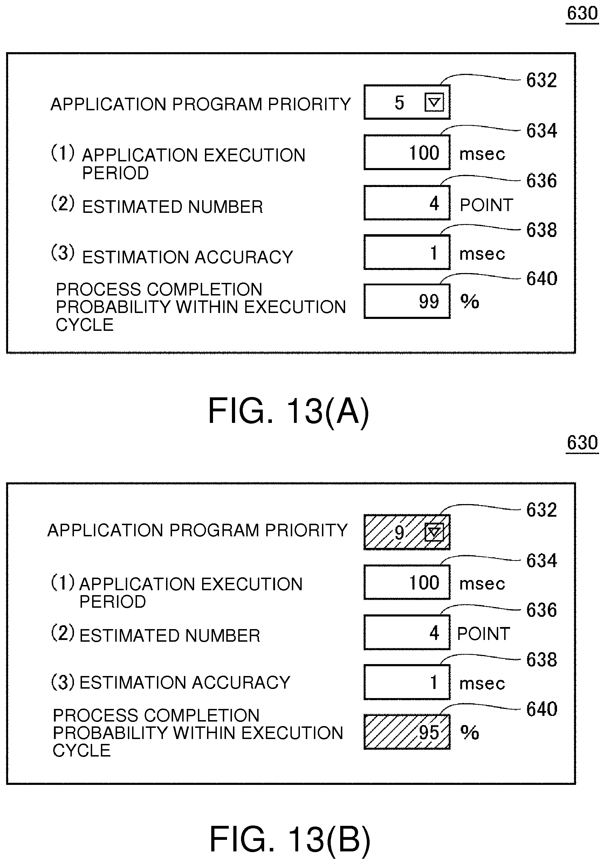

FIG. 13(A) and FIG.13(B) are schematic diagrams respectively showing still another example of the user interface screen which is provided by the support device 200 according to the embodiment. A user interface screen 630 shown in FIG. 13(A) and FIG.13(B) provides an interface for adjusting various parameters by the user.

Referring to FIG. 13(A), more specifically, the user interface screen 630 includes a display window 632 which shows the priority, a display window 634 which shows the length of the application execution cycle, a display window 636 which shows the number of the passage points used to generate the internal command 40, and a display window 638 which shows a gap between the passage points calculated when generating the internal command 40.

The display window 640 displays the value of the process completion probability within the execution cycle corresponding to each of the values respectively set to the display windows 632, 634, 636, and 638.

The user can arbitrarily change the value set to each of the display windows 632, 634, 636, and 638.

Referring to FIG. 13(B), for example, when the value of the priority displayed in the display window 632 is changed, the process completion probability within the execution cycle is calculated again in accordance with the changed priority and the value of the updated process completion probability within the execution cycle is displayed in the display window 640.

Further, when an arbitrary value displayed in the display windows 634, 636, and 638 is changed, the computation load value for the target application program 32 is calculated again and the process completion probability within the execution cycle is calculated again based on the updated computation load value.

The user can easily recognize whether the parameters for generating the internal command and the priority are appropriate by changing an arbitrary parameter on the user interface screen 630 shown in FIG. 13 to an arbitrary value and checking the value of the process completion probability within the execution cycle at that time.

### <J. Process Procedure>

Next, an example of a process procedure of the priority calculation process according to the embodiment will be described.

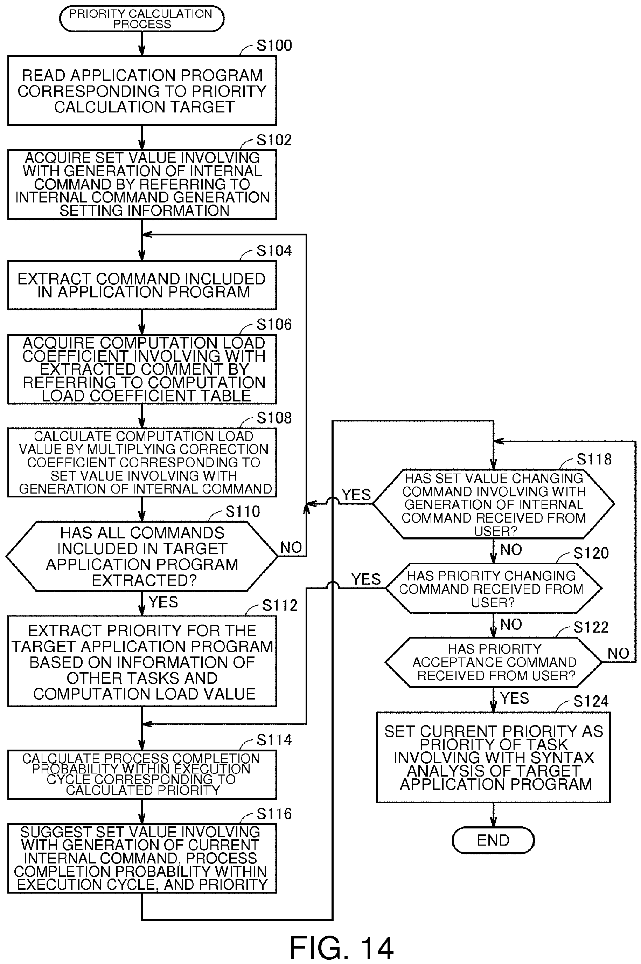

FIG. 14 is a flowchart showing a process procedure of the priority calculation process according to the embodiment. Each of the steps shown in FIG. 14 is typically realized when the processor 202 of the support device 200 executes the support program 218.

Referring to FIG. 14, the support device 200 reads application program 32 which is a priority calculation target (step S100). Further, the support device 200 acquires the set value involving with the generation of the internal command by referring to the internal command generation setting information 58 (step S102). The set value involving with the generation of the internal command includes the length of the application execution cycle, the number of the passage points used to generate the internal command 40, and the gap between the calculated passage points.

The support device 200 extracts the command included in the application program 32 by analyzing the syntax of the read application program 32 (step S104) and acquires the computation load coefficient corresponding to the extracted command by referring to the computation load coefficient table 56 (step S106). Further, the support device 200 calculates the computation load value by multiplying the correction coefficient corresponding to the set value involving with the generation of the internal command acquired in step S102 by the acquired computation load coefficient (step S108). The calculated computation load values are sequentially stored.

Next, the support device 200 determines whether all commands included in the target application program 32 are completely extracted (step S110). When the command included in the target application program 32 is not completely extracted yet (NO in step S110), the process from step S104 is repeated.

When all commands included in the target application program 32 are completely extracted (YES in step S110), the support device 200 calculates the priority for the target application program 32 based on the information of other tasks set to the task setting information 64 and the computation load value calculated in step S108 (step S112). Then, the support device 200 calculates the process completion probability within the execution cycle corresponding to the calculated priority (step S114).

Next, the support device 200 receives the operation from the user by suggesting the calculated priority, the calculated process completion probability within the execution cycle, and the set value involving with the generation of the current internal command to the user (step S116).

When a command of changing the set value involving with the generation of the internal command is received from the user (YES in step S118), the process from step S104 is repeated. Accordingly, the priority and the process completion probability within the execution cycle are calculated again.

Further, when the priority changing command is received from the user (YES in step S120), the process from step S114 is repeated. Accordingly, the process completion probability within the execution cycle is calculated again.

Further, when the priority acceptance command is received from the user (YES in step S122), the support device 200 sets the current priority as the priority of the task involving with the syntax analysis of the target application program 32 (step S124). More specifically, the set priority is registered in the internal command generation setting information 58. Then, the process ends.

By the above-described process procedure, an appropriate priority for an arbitrary application program 32 can be set.

### <K. Process of Learning Computation Load Coefficient Table>

Next, an example of a process of learning the computation load coefficient table 56 based on actual load information will be described.

As described above, in the priority calculation process according to the embodiment, the computation load value of the application program 32 is calculated by referring to the computation load coefficient table 56. In general, a value of the computation load coefficient specified in the computation load coefficient table 56 is a theoretical value and the value of the actual computation load coefficient may be changed depending on the program execution environment or the like.

Here, the value of the computation load coefficient specified in the computation load coefficient table 56 may be improved by learning the computation load coefficient table 56 based on the actual load information.

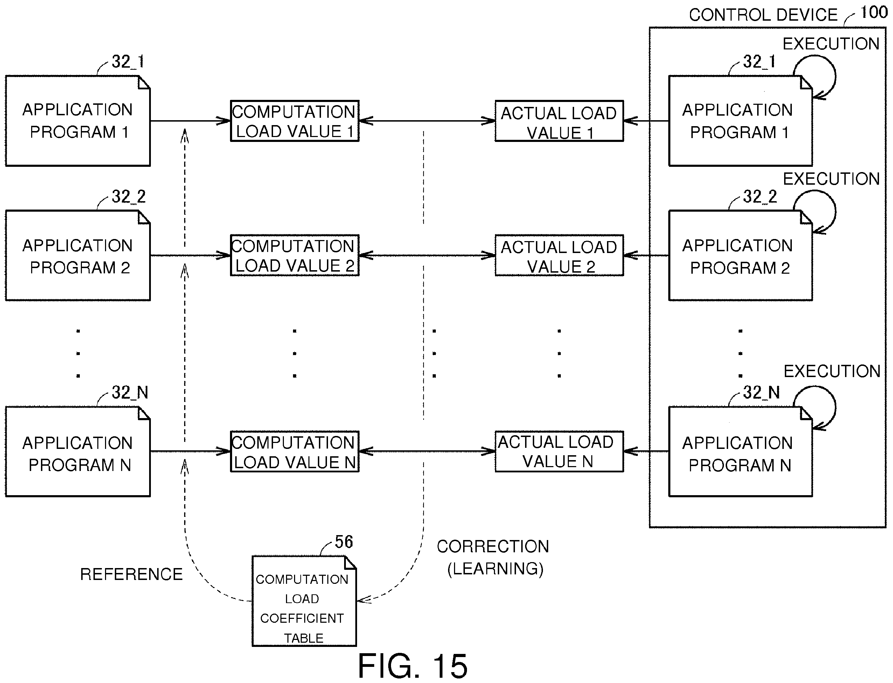

FIG. 15 is a schematic diagram illustrating a process of learning the computation load coefficient table 56 in the priority calculation process according to the embodiment. Referring to FIG. 15, for example, it is assumed that computation load values 1, 2, ... , N are respectively calculated from a plurality of application programs 32_1, 32_2, ... , 32_N by referring to the computation load coefficient table 56.

Meanwhile, actual load values 1, 2, ... , N indicating the actual computation loads when executing the plurality of application programs 32_1, 32_2, ... , 32_N by the control device 100 are measured. Each of the actual load values 1, 2, ... , N indicates, for example, the degree of the load calculated from the processor time or the processor time necessary for the syntax analysis process.

Based on the comparison results 1, 2, ... , N obtained by comparing the computation load values 1, 2, ... , N with the actual load values 1, 2, ... , N, the computation load coefficient table 56 may be corrected (learned). In this learning, the value of the computation load coefficient described in the computation load coefficient table 56 is adjusted so that the comparison results 1, 2, ..., N (that is, errors) become zero.

In this way, the support device 200 may have a learning function of acquiring the execution state of the task of analyzing the syntax of the application program 32 in the control device 100 and updating the computation load coefficient table 56 (the computation load coefficient information) based on the acquired execution state.

When the value of the computation load coefficient described in the computation load coefficient table 56 is repeatedly adjusted, the accuracy of the computation load coefficient table 56 can be improved.

Additionally, FIG. 15 shows an example in which the plurality of application programs 32_1, 32_2, ... , 32_N are processed in parallel for convenience of description, but the present invention is not limited thereto. Then, a learning process may be executed for each application program 32 a plurality of times.

Further, the computation load coefficient table 56 may be learned based on the information from the plurality of control devices 100. In this case, comparison results respectively acquired from the control devices 100 may be accumulated in a server or the like and the value of the computation load coefficient specified in the computation load coefficient table 56 may be adjusted in the server.

In this way, when the information from the control devices 100 is used, it is possible to improve the accuracy of the computation load coefficient table 56 and to obtain the generalized computation load coefficient.

### <L. Calculation of Priority using Emulator>

In the description above, a method of calculating the computation load by analyzing the syntax of the application program 32 has been exemplified, but the priority may be calculated after estimating the actual load information using the emulator in addition to or instead of the syntax analysis method.

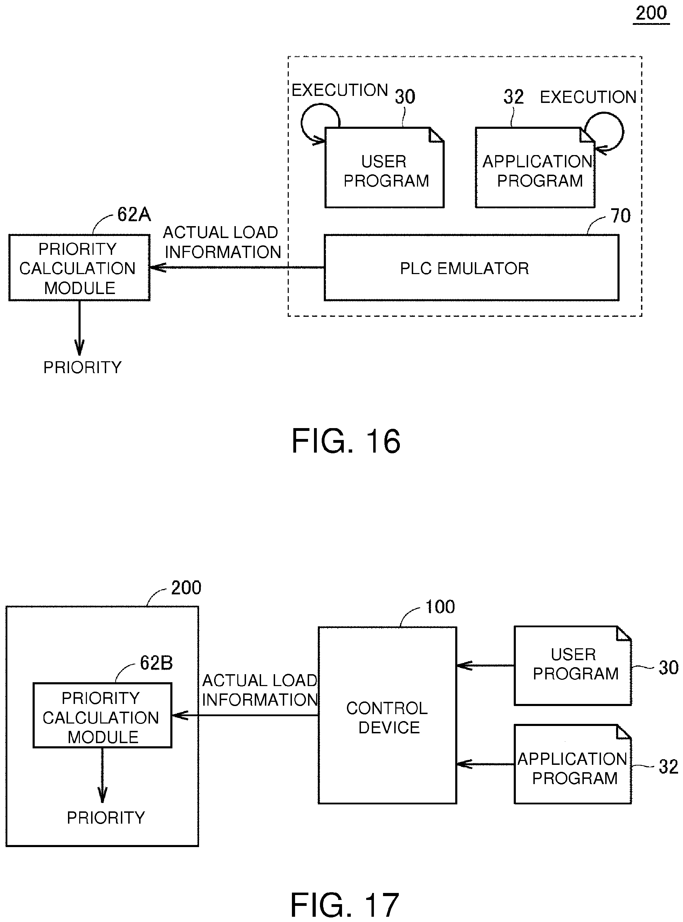

FIG. 16 is a schematic diagram illustrating a priority calculation process using the emulator according to the embodiment. Referring to FIG. 16, the support device 200 includes a PLC emulator 70. The PLC emulator 70 has a functional configuration of simulating the control device 100 shown in FIG. 5 and is software which virtually provides a configuration which is substantially the same as the function provided by the control device 100. That is, the PLC emulator 70 can execute the same process as the control device 100.

As shown in FIG. 16, the user program 30 and the application program 32 are executed in the PLC emulator 70 similarly to the execution of the program of the control device 100. The PLC emulator 70 outputs actual load information generated by the execution of the program of the PLC emulator 70 and representing the degree of the actual computation load.

The support device 200 includes a priority calculation module 62A. The priority calculation module 62A has the same function as the priority calculation module 62 shown in FIG. 8 and calculates an appropriate priority set for the task of analyzing the syntax of the application program 32 based on the actual load information from the PLC emulator 70. In this way, the priority calculation module 62A calculates the priority to be set for the task of analyzing the syntax of the application program 32 based on the degree of the actual computation load acquired by the execution of the tasks in the PLC emulator 70.

As described above, since the priority is calculated by using the emulator, it is possible to calculate the priority which further reflects the execution state of the application program 32 in the actual control device 100.

### <M. Calculation of Priority using Actual Device>

In the description above, a method of calculating the priority by estimating the actual load information (the actual load information) using the emulator has been described, but the priority may be calculated by acquiring the actual load information generated by the execution of the program in the actual control device 100.

FIG. 17 is a schematic diagram illustrating a priority calculation process using an actual device according to the embodiment. Referring to FIG. 17, the control device 100 executes the user program 30 and the application program 32. The control device 100 outputs the actual load information which is generated by the execution of the program in the control device 100 and representing the degree of the actual computation load.

The support device 200 includes a priority calculation module 62B. The priority calculation module 62B has the same function as the priority calculation module 62 shown in FIG. 8 and calculates an appropriate priority set for the task of analyzing the syntax of the application program 32 based on the actual load information from the control device 100. In this way, the priority calculation module 62B calculates the priority to be set for the task of analyzing the syntax of the application program 32 based on the degree of the actual computation load acquired by the execution of the tasks in the control device 100.

When the priority is calculated based on the actual load information obtained by the execution of the program in the actual control device 100 as described above, it is possible to calculate the priority reflecting the actual execution state of the application program 32.

### <N. Appendix>

The above-described embodiment includes the following technical spirit.

### [Configuration 1]

A support device (200) connected to a control device (100) including one or a plurality of processors, the control device being configured to process a plurality of tasks based on priorities respectively set to the tasks, wherein the plurality of tasks includes a first task (10, 18) which includes a process of outputting a control command every first cycle according to an internal command, a second task (20) which includes a process of sequentially generating the internal command by analyzing a syntax of at least a part of an application program described by an interpreter language every second cycle longer than the first cycle, and a third task (22, 24) which includes a process different from the first task and the second task, and wherein the support device includes: a load estimation means (52, 54) which calculates a degree of a load necessary for analyzing a syntax of a command included in the application program; and a priority calculation means (62) which calculates a priority to be set for the second task based on the calculated degree of the load.

### [Configuration 2]

The support device according to configuration 1, further including: a suggestion means (66) which suggests a priority to be set for the second task to a user.

### [Configuration 3]

The support device according to configuration 1 or 2, further including: a setting means (68) which reflects the setting of the priority for the second task in response to an input of the user.

### [Configuration 4]

The support device according to any one of configurations 1 to 3, wherein the application program includes one or a plurality of commands for defining a target trajectory, wherein the second task includes a process of sequentially calculating passage points on the target trajectory and a process of generating the internal command based on a movement route including the plurality of calculated passage points, and wherein the load estimation means calculates the degree of the load by reflecting at least one of a gap between the calculated passage points, the number of the passage points used to generate the internal command, and a length of the second cycle.

### [Configuration 5]

The support device according to any one of configurations 1 to 4, wherein the load estimation means calculates the degree of the load by referring to computation load coefficient information (56) specifying a computation load coefficient for each command.

### [Configuration 6]

The support device according to configuration 5, further including: a learning means which acquires an execution state of the second task in the control device and updates the computation load coefficient information based on the acquired execution state.

### [Configuration 7]

The support device according to any one of configurations 1 to 6, further including: an emulator (70) which simulates the control device; and a second priority calculation means (62A) which calculates a priority to be set for the second task based on a degree of an actual computation load acquired by executing the tasks in the emulator.

### [Configuration 8]

The support device according to any one of configurations 1 to 7, further including: a third priority calculation means (62B) which calculates a priority to be set for the second task based on the degree of the actual computation load acquired by executing the tasks in the control device.

### [Configuration 9]

A support program for realizing a support device (200) connected to a control device (100) including one or a plurality of processors (102), the control device being configured to process a plurality of tasks based on priorities respectively set to the tasks, wherein the plurality of tasks includes a first task (10, 18) which includes a process of outputting a control command every first cycle according to an internal command, a second task (20) which includes a process of sequentially generating the internal command by analyzing a syntax of at least a part of an application program described by an interpreter language every second cycle longer than the first cycle, and a third task (22, 24) which includes a process different from the first task and the second task, and wherein the support program causes a computer to execute: a step (S104, S106, S108) of calculating a degree of a load necessary for analyzing a syntax of a command included in the application program; and a step (S112) of calculating a priority to be set for the second task based on the calculated degree of the load.

### <O. Advantage>

When executing a plurality of tasks by sharing the processor resources, the support device according to the embodiment can consider the degree of the load actually generated by the process set in the focused task and then estimate the priority to be set for the task in advance. By such previous priority estimation, it is possible to omit an effort of determining the priority by executing a program in the control device with trial and error. Further, it is possible to recognize the appropriate priority to be set for the task even by the user having insufficient knowledge.

Since the support device according to the embodiment can calculate the degree of the load corresponding to each command by analyzing the syntax of the application program, it is possible to more accurately calculate the degree of the load and to calculate the priority based on the result thereof.

Since the support device according to the embodiment can suggest the information of the set priority and the degree of the load involving with the execution of the application program to the user, the user can easily acquire more useful information when setting the priority for the task.

### Reference Signs List

1 Control system
2 Field network
6 High-order network
10 First task
12 Sequence command execution process
14, 16 Output process
18 Second task
20 Third task
22 Fourth task
24 Fifth task
30 User program
32 Application program
34 System program
38 Recipe information
40 Internal command
44 Movement route
50 Load estimation process
52 Syntax analysis module
54 Computation load calculation module
56 Computation load coefficient table
58 Internal command generation setting information
60 Priority calculation process
62, 62A, 62B Priority calculation module
64, 156 Task setting information
66 Dialogue module
68 Setting module
70 Emulator
100 Control device
200 Support device
102, 202 Processor
104 Chipset
106, 206 Main memory
108, 208 Storage
110 High-order network controller
112, 212 USB controller
114 Memory card interface
116 Memory card
120 Internal bus controller
122 I/O unit
130 Field network controller
150 PLC processing engine
152 Sequence program execution unit
154 Scheduler
160 Application analysis unit
162 Application adjustment unit
164 Control command calculation unit
170 Shared memory
172 Shared memory control unit
174 Display function unit
176 Field network interface
178 High-order network interface
204 Display
210 Internal bus
214 Input device
216 OS
218 Support program
300 Server device
400 Display device
500 Field device
510 Remote I/O device
520 Robot
522 Robot controller
530 Machine tool
532 Servomotor
534 Conveyor
536 Work table
538 Servo driver
541 Computation load coefficient reference module
542, 544, 546 Coefficient calculation module
543, 545, 547 Coefficient multiplication module
548 Statistics processing module
621 Priority table
624 Task attribute information
W Work.

## Claims

1. A support device (200) connected to a control device (100) including one or a plurality of processors (102), the control device (100) being configured to process a plurality of tasks (10, 18, 20, 22, 24) based on priorities set for each of the tasks (10, 18, 20, 22, 24),
wherein the plurality of tasks includes a first task (10, 18) which includes a process of outputting a control command every first cycle (T1) according to an internal command, a second task (20) which includes a process of sequentially generating the internal command by analyzing a syntax of at least a part of an application program (32) described by an interpreter language every second cycle longer than the first cycle, and a third task (22, 24) which includes a different process from the first task (10, 18) and the second task (20), and
wherein the support device (200) comprises:
a load estimation means (52, 54) which calculates a degree of a load necessary for analyzing a syntax of a command included in the application program; and
a priority calculation means (62) which calculates a priority to be set for the second task based on the calculated degree of the load.

2. The support device according to claim 1, further comprising a suggestion means (66) which suggests a priority to be set for the second task to a user.

3. The support device according to claim 1 or 2, further comprising a setting means (68) which reflects the setting of the priority for the second task in response to an input of the user.

4. The support device according to any one of claims 1 to 3,
wherein the application program includes one or a plurality of commands for defining a target trajectory,
wherein the second task includes a process of sequentially calculating passage points on the target trajectory and a process of generating the internal command based on a movement route including the plurality of calculated passage points, and
wherein the load estimation means calculates the degree of the load by reflecting at least one of a gap between the calculated passage points, the number of the passage points used to generate the internal command, and a length of the second cycle.

5. The support device according to any one of claims 1 to 4, wherein the load estimation means calculates the degree of the load by referring to computation load coefficient information (56) specifying a computation load coefficient for each command.

6. The support device according to claim 5, further comprising a learning means which acquires an execution state of the second task in the control device and updates the computation load coefficient information based on the acquired execution state.

7. The support device according to any one of claims 1 to 6, further comprising:
an emulator (70) which simulates the control device; and
a second priority calculation means (62A) which calculates a priority to be set for the second task based on a degree of an actual computation load acquired by executing the tasks in the emulator.

8. The support device according to any one of claims 1 to 7, further comprising a third priority calculation means (62B) which calculates a priority to be set for the second task based on the degree of the actual computation load acquired by executing the tasks in the control device.

9. A support program for realizing a support device (200) connected to a control device (100) including one or a plurality of processors (102), the control device (100) being configured to process a plurality of tasks based on priorities set for each of the tasks,
wherein the plurality of tasks includes a first task (10, 18) which includes a process of outputting a control command every first cycle according to an internal command, a second task (20) which includes a process of sequentially generating the internal command by analyzing a syntax of at least a part of an application program described by an interpreter language every second cycle longer than the first cycle, and a third task (22, 24) which includes a different process from the first task and the second task, and
wherein the support program causes a computer to execute:
calculating a degree of a load necessary for analyzing a syntax of a command included in the application program; and
calculating a priority to be set for the second task based on the calculated degree of the load.

## Amended claims

### Amended claims in accordance with Rule 137(2) EPC.

1. A support device (200) configured for being connected to a control device (100) including one or a plurality of processors (102), the control device (100) being configured to process a plurality of tasks (10, 18, 20, 22, 24) based on priorities set for each of the tasks (10, 18, 20, 22, 24),
wherein the plurality of tasks includes a first task (10, 18) which includes a process of outputting a control command every first cycle (T1) according to an internal command, a second task (20) which includes a process of sequentially generating the internal command by analyzing a syntax of at least a part of an application program (32) described by an interpreter language every second cycle longer than the first cycle, and a third task (22, 24) which includes a different process from the first task (10, 18) and the second task (20), and
wherein the support device (200) is **characterized by** comprising:
a load estimation means (52, 54) which is configured to calculate a degree of a load necessary for analyzing a syntax of a command included in the application program; and
a priority calculation means (62) which is configured to calculate a priority to be set for the second task based on the calculated degree of the load.

2. The support device according to claim 1, further comprising a suggestion means (66) which suggests a priority to be set for the second task to a user.

3. The support device according to claim 1 or 2, further comprising a setting means (68) which reflects the setting of the priority for the second task in response to an input of the user.

4. The support device according to any one of claims 1 to 3,
wherein the application program includes one or a plurality of commands for defining a target trajectory,
wherein the second task includes a process of sequentially calculating passage points on the target trajectory and a process of generating the internal command based on a movement route including the plurality of calculated passage points, and
wherein the load estimation means calculates the degree of the load by reflecting at least one of a gap between the calculated passage points, the number of the passage points used to generate the internal command, and a length of the second cycle.

5. The support device according to any one of claims 1 to 4, wherein the load estimation means calculates the degree of the load by referring to computation load coefficient information (56) specifying a computation load coefficient for each command.

6. The support device according to claim 5, further comprising a learning means which acquires an execution state of the second task in the control device and updates the computation load coefficient information based on the acquired execution state.

7. The support device according to any one of claims 1 to 6, further comprising:
an emulator (70) which simulates the control device; and
a second priority calculation means (62A) which calculates a priority to be set for the second task based on a degree of an actual computation load acquired by executing the tasks in the emulator.

8. The support device according to any one of claims 1 to 7, further comprising a third priority calculation means (62B) which calculates a priority to be set for the second task based on the degree of the actual computation load acquired by executing the tasks in the control device.

9. A support program for realizing a support device (200) connected to a control device (100) including one or a plurality of processors (102), the control device (100) being configured to process a plurality of tasks based on priorities set for each of the tasks,
wherein the plurality of tasks includes a first task (10, 18) which includes a process of outputting a control command every first cycle (Tl) according to an internal command, a second task (20) which includes a process of sequentially generating the internal command by analyzing a syntax of at least a part of an application program (32) described by an interpreter language every second cycle longer than the first cycle, and a third task (22, 24) which includes a different process from the first task (10, 18) and the second task (20), and
wherein the support program is **characterized by** causing a computer to execute:
calculating a degree of a load necessary for analyzing a syntax of a command included in the application program; and
calculating a priority to be set for the second task based on the calculated degree of the load.
